# EUROPÄISCHE PATENTSCHRIFT

(11) **EP 3 611 498 B1**
(45) Veröffentlichungstag und Bekanntmachung des Hinweises auf die Patenterteilung: **17.03.2021**
(21) Anmeldenummer: 18189149.0
(22) Anmeldetag: 15.08.2018
(51) Int. Cl.: G01N 27/28, B65D 85/20, B65D 85/38

(54) **SCHUTZVORRICHTUNG FÜR ELEKTROCHEMISCHE ELEKTRODEN MIT EINER FLÜSSIGKEITSVERBINDUNG**
PROTECTION DEVICE FOR ELECTROCHEMICAL ELECTRODES WITH A LIQUID JUNCTION
DISPOSITIF DE PROTECTION POUR ÉLECTRODES ÉLECTROCHIMIQUES À JONCTION LIQUIDE

(43) Veröffentlichungstag der Anmeldung: 19.02.2020
(73) Patentinhaber: Mettler-Toledo GmbH, 8606 Greifensee (CH)
(72) Erfinder: BARCELLA, Corrado, 5304 Endingen (CH); EHRISMANN, Philippe, 8610 Uster (CH)
(74) Vertreter: Mettler-Toledo

(56) Entgegenhaltungen:
- CH-B1- 701 837
- DE-A1- 4 421 062
- DE-A1-102014 101 759

## Beschreibung

Die Erfindung betrifft eine Schutzvorrichtung für elektrochemische Elektroden mit einer Flüssigkeitsverbindung (eng. liquid junction), zum Schutz der Elektrode bei dem Transport, der Lagerung und/oder der Aufbewahrung, sowie ein Transport- und Aufbewahrungs-System mit einer derartigen Schutzvorrichtung und einer solchen elektrochemischen Elektrode.

Elektrochemische Elektroden mit einer Flüssigkeitsverbindung sind beispielsweise Referenzelektroden, welche zusammen mit einer Arbeitselektrode und/oder einer Gegenelektrode eingesetzt werden. Weiterhin sind Einstabmessketten als elektrochemische Elektroden mit Flüssigkeitsverbindung bekannt, welche eine elektrochemische Referenzelektrode und eine Messelektrode in einem gemeinsamen Gehäuse umfassen. Die Flüssigkeitsverbindung besteht zwischen einem in der Elektrode angeordneten Elektrolyten oder Referenzelektrolyten und dem Messmedium und stellt im Betrieb bzw. bei einem Messvorgang eine elektrochemische Verbindung zwischen Referenzelektrolyt und dem zu messenden Medium dar.

Eine elektrochemische Elektrode als Referenzelektrode umfasst unter anderem ein Gehäuse, in welchem ein Referenzelektrolyt, ein in diesen Referenzelektrolyten eintauchendes Referenz-Ableitelement und die Flüssigkeitsverbindung (eng. liquid junction) angeordnet sind. Die Flüssigkeitsverbindung kann als offenes Loch, als Membran oder Diaphragma in der Gehäusewand ausgebildet sein.

Unter dem Begriff "bedruckte" Elektrode werden Elektroden verstanden, deren Elektrolyt unter leichtem Überdruck steht, so dass der Elektrolyt kontinuierlich durch die Flüssigkeitsverbindung austritt. Dies dient dazu eine Verunreinigung des Elektrolyten zu verhindern. Solche bedruckten Elektroden umfassen häufig ein Diaphragma als Flüssigkeitsverbindung in Kombination mit einem flüssigen Elektrolyten. Diese werden insbesondere als Referenzelektroden alleine oder in Einstabmessketten eingesetzt.

Für den Transport, die Lagerung und/oder die Aufbewahrung von Elektroden mit einer Flüssigkeitsverbindung (eng. liquid junction) muss diese verschlossen werden, um ein Auslaufen des Elektrolyten und/oder den teilweise oder vollständigen Abbau des Überdrucks zu verhindern und so die Funktionsfähigkeit der Elektrode nach dem Transport, der Lagerung und/oder der Aufbewahrung zu gewährleisten. Dieses Verschliessen erfolgt beispielsweise durch Aufbringen eines Tropfens eines Klebers auf die Flüssigkeitsverbindung, welcher nachträglich ausgehärtet wird. Ebenfalls ist die Verwendung anderer Dichtmasse bekannt, um das Auslaufen des und/oder einen Druckabfall im Elektrolyten zu verhindern. Vor der Verwendung der elektrochemischen Elektrode muss der Kleber, bzw. die Dichtmasse allerdings wieder entfernt werden.

Nachteilig an dieser Methode zur Abdichtung der Flüssigkeitsverbindung ist, dass es aufwändig und kritisch ist, den Kleber oder die Dichtmasse einerseits aufzubringen als sowie diesen vor dem Einsatz der elektrochemischen Elektrode wieder vollständig zu entfernen ohne die Flüssigkeitsverbindung zu beschädigen. Beispielsweise können Reste des Kleber oder der Dichtmasse auf dem Gehäuse bzw. dem Schaft der Elektrode verbleiben und schlimmstenfalls das zu untersuchende Medium kontaminieren. Wird die Entfernung des Klebers oder der Dichtmasse vergessen, so würde die Elektrode gar nicht funktionieren. Da bedruckte Elektroden nicht nur im Labor sondern auch in Prozessanlagen eingesetzt werden, muss die Abdichtung zwingend vor einem Einbau in eine Prozessanlage entfernt werden.

Aufgabe der Erfindung ist es, eine Schutzvorrichtung zu entwickeln, die in ihrem Gebrauchszustand dem mechanischen Schutz der elektrochemischen Elektrode mit Flüssigkeitsverbindung während deren Transport, Lagerung und/oder Aufbewahrung dient und welche zudem gewährleistet, dass ein Überdruck im Elektrolyten aufrecht erhalten bleibt.

Diese Aufgaben werden gelöst mit einer Schutzvorrichtung für elektrochemische Elektroden mit Flüssigkeitsverbindung sowie einem System zur Lagerung, Transport und/oder Aufbewahrung einer derartigen elektrochemischen Elektrode gemäss den unabhängigen Ansprüchen.

Eine Schutzvorrichtung für elektrochemische Elektroden mit einer Flüssigkeitsverbindung umfasst ein Gehäuse, welches als Hohlzylinder ausgestaltet ist und welches einen in seinem Inneren umlaufenden ersten Absatz aufweist, welcher in das Innere des Gehäuses hineinragt. Die Schutzvorrichtung umfasst zudem ein Begrenzungsmittel, welches zusammen mit dem ersten Absatz ein erstes Gehäusesegment mit einem ersten Innendurchmesser begrenzt; ein Zwischenstück, welches als Hohlzylinder mit einem dem ersten Innendurchmesser entsprechenden Aussendurchmesser ausgestaltet ist; sowie einen ersten Dichtring und einen zweiten Dichtring, zwischen denen das Zwischenstück angeordnet ist. Der erste Dichtring, der zweite Dichtring und das Zwischenstück sind im Inneren des ersten Gehäusesegments angeordnet, so dass der erste Dichtring und der zweite Dichtring einen ersten Schutzraum oder eine Schutzkammer für die Flüssigkeitsverbindung einer elektrochemischen Elektrode begrenzen, dessen Aussendurchmesser dem Innendurchmesser des Zwischenstücks entspricht.

Die Schutzvorrichtung ist derart ausgestaltet, dass diese im Gebrauchszustand soweit über oder auf eine Elektrode geschoben werden kann, dass deren Flüssigkeitsverbindung im ersten Schutzraum angeordnet ist. Um dieses zu gewährleisten entspricht der kleinste Innendurchmesser der die Schutzvorrichtung bildenden Bauteile im Wesentlichen dem Aussendurchmesser der zu schützenden Elektrode. Im Gebrauchszustand schliessen die beiden Dichtringe den ersten Schutzraum gegen das äussere Umfeld der Elektrode ab und ermöglichen, dass ein im Inneren der Elektrode angeordneter Elektrolyt nur in den ersten Schutzraum austritt, welcher ein sehr kleines Volumen hat, so dass kaum Elektrolyt aus der Elektrode austreten kann. Im Falle einer bedruckten Elektrode, bei der der Elektrolyt unter einem gewissen Überdruck steht, kann so zudem ein Druckabfall im Wesentlichen verhindert werden.

Die erfindungsgemässe Schutzvorrichtung erlaubt es elektrochemische Elektroden sicher zu transportieren, zu lagern oder aufzubewahren. Dabei bleibt der Überdruck innerhalb der Elektrode erhalten, für den Fall, dass diese in der Schutzvorrichtung angeordnet ist und sich die Schutzvorrichtung somit in ihrem Gebrauchszustand befindet.

Die Schutzvorrichtung zeichnet sich ferner dadurch aus, dass sie wiederverwendbar ist. So kann diese beispielsweise im Labor bei Nichtgebrauch der Elektrode eingesetzt werden und kann für Messungen einfach entfernt werden.

Das Zwischenstück besitzt einen Aussendurchmesser, der ungefähr dem Innendurchmesser des ersten Gehäusesegments entspricht und eine Wandstärke, die ungefähr der Tiefe des ersten Absatzes entspricht.

Der erste und der zweite Dichtring sind vorzugsweise elastisch verformbar und somit komprimierbar. Zudem weisen die beiden Dichtringe jeweils einen äusseren Ringdurchmesser auf, der ungefähr dem Innendurchmesser des ersten Gehäusesegments entspricht und einen Schnurdurchmesser der ungefähr der Tiefe des ersten Absatzes entspricht.

In einer Ausführungsform ist das Begrenzungsmittel als zweiter Absatz in Inneren des Gehäuses ausgestaltet.

Der erste Schutzraum wird vom ersten und zweiten Dichtring und dem zwischen diesen beiden Dichtringen angeordnetem Zwischenstück begrenzt, wobei das Zwischenstück mit etwas Spiel oder beweglich im Gehäuse angeordnet ist, so dass im Gebrauchszustand die beiden Dichtringe beidseitig gegen das Zwischenstück sowie auch gegen die Elektrode dichtend anliegen können, wobei der erste Dichtring zudem am ersten Absatz anliegt.

In einer weiteren Ausführungsform umfasst das Gehäuse ein erstes Verbindungsmittel und die Schutzvorrichtung umfasst ferner ein Befestigungselement, welches als Hohlzylinder ausgestaltet ist und das Begrenzungsmittel sowie ein zweites Verbindungsmittel zur Verbindung des Befestigungselements mit dem Gehäuse umfasst; wobei das Begrenzungsmittel an einem ersten Ende des Befestigungselements angeordnet ist, so dass im zusammengebauten Zustand oder im Gebrauchszustand das Begrenzungsmittel gegen den zweiten Dichtungsring gepresst wird und so Druck auf den ersten und zweiten Dichtring ausübt.

Bei dieser Ausführungsform liegt, im montierten bzw. zusammengesetzten Zustand oder im Gebrauchszustand der Schutzvorrichtung, der erste Dichtring am ersten Absatz und an einer ersten Stirnseite des Zwischenstücks an. Der zweite Dichtring liegt am Begrenzungsmittel des Befestigungselements und einer zweiten Stirnseite des Zwischenstücks an. Dabei sind das Gehäuse und das Befestigungselement mittels des ersten und des zweiten Verbindungselements miteinander verbunden.

Der montierte Zustand der Schutzvorrichtung zeichnet sich dadurch aus, dass das Gehäuse mit dem Befestigungselement verbunden ist, jedoch noch keine Kraftwirkung auf die im Inneren des Gehäuses befindlichen Teile, insbesondere das Zwischenstück sowie die beiden Dichtungsringe, erfolgt. In diesem Zustand befindet sich keine Elektrode in der Schutzvorrichtung

Die Schutzvorrichtung befindet sich im Gebrauchszustand, wenn diese auf eine sich nicht im Einsatz befindliche elektrochemische Elektrode aufgesetzt ist, diese also teilweise umschliesst und das Gehäuse mit dem Befestigungselement lösbar verbunden ist, jedoch eine Kraftwirkung auf die im Inneren des Aufsatzkörpers befindlichen Teile, namentlich das Zwischenstück sowie die beiden Dichtungsringe, erfolgt.

In einer Ausgestaltung ist das erste Verbindungsmittel als Innengewinde und das zweite Verbindungsmittel als Aussengewinde ausgestaltet ist, so dass das Befestigungselement in das Gehäuse eingeschraubt werden kann. Auf diese Weise kann das Befestigungselement zudem über das Begrenzungselement Druck auf die beiden Dichtringe und das Zwischenstück ausüben, insbesondere wenn zudem eine elektrochemische Elektrode in der Schutzvorrichtung angeordnet ist.

In einer weiteren Ausgestaltung sind das erste Verbindungsmittel und das zweite Verbindungsmittel als Teile einer Bajonettverbindung ausgestaltet, so dass diese beim Verbinden des Gehäuses und des Befestigungselement formschlüssig ineinander greifen. Zudem wird in dieser Ausgestaltung der auf die beiden Dichtringe und das Zwischenstück einwirkende Druck durch die eindeutige "ZU" Stellung des BajonettVerschlusses festgelegt werden. Ein Bajonett-Verschluss rastet in seiner "ZU" Stellung ein, so dass der durch das Begrenzungsmittel ausgeübte Druck immer gleich ist.

Weiterhin kann das Befestigungselement an einem zweiten Ende ein strukturiertes Griffsegment umfasst, wobei das zweite Ende dem Begrenzungsmittel gegenüber liegt. Das strukturierte Griffsegment kann beispielsweise eine Rändelung oder andersartige Ausprägungen aufweisen, die es einem Nutzer ermöglichen das Befestigungselement besser zu greifen und zu handhaben.

In einer weiteren Ausgestaltung umfasst das Befestigungselement ferner einen Wulst, welche zwischen dem Griffsegment und dem Begrenzungselement angeordnet ist. Dieser umlaufende Wulst greift im montierten oder zusammengebauten Zustand mit Spiel in eine Nut am Gehäuse ein und bildet so einen Anschlag für das Befestigungselement. Auf diese Weise wird gewährleistet, dass das Befestigungselement im Gehäuse einrastet und nur unter Kraftaufwand wieder entfernt werden kann. Zudem dient der aus Nut und Wulst gebildete Anschlag dazu die Eindringtiefe des Befestigungselements zu beschränken und damit auch den durch das Begrenzungsmittel über die Dichtringe auf das Zwischenstück ausgeübten Druck. Das ist insbesondere bei der Verwendung der Schutzvorrichtung für Glaselektroden wichtig, da so ein versehentliches Zerdrücken des Glasschafts beim Befestigen der Schutzvorrichtung verhindert werden kann.

Der Wulst kann zudem auch als Dichtlippe ausgestaltet sein oder wirken, welche das erste Gehäusesegment zusätzlich abdichtet.

Das Gehäuse kann ferner ein zweites Gehäusesegment umfassen, welches ebenfalls als Hohlzylinder ausgestaltet ist und endständig mit dem ersten Gehäusesegment verbunden ist.

Das zweite Gehäusesegment kann eine Verlängerung des ersten Gehäusesegments darstellen, welches im Gebrauchszustand einen Messbereich der elektrochemischen Elektrode umgibt und diesen vor mechanischer Belastung schützt. Bevorzugt sind das erste und zweite Gehäusesegment fest miteinander verbunden oder als ein einziges Bauteil ausgestaltet.

In einer weiteren Ausgestaltung ist das zweite Gehäusesegment einseitig geschlossen, genauer endständig, so dass im Inneren des zweiten Gehäusesegments ein zweiter Schutzraum oder eine zweite Schutzkammer zur Aufnahme einer Befeuchtungsflüssigkeit ausgebildet ist. In diesen zweiten Schutzraum ragt im Gebrauchszustand der Messbereich der elektrochemischen Elektrode. Zusätzlich kann der zweite Schutzraum mit einer Elektrolytlösung gefüllt sein und dazu dienen den Messbereich der elektrochemischen Elektrode während des Transports, der Lagerung und/oder der Aufbewahrung feucht zu halten. Dies ist insbesondere bei Einstabmessketten zur pH-Bestimmung mit einer Referenzelektrode und einer Messelektrode mit einer pH-sensitiven-Glasmembran relevant, da diese pH-Glasmembran nicht austrocknen darf.

Aus diesem Grund sind für Sensoren mit sensitiven Glasmembranen, insbesondere für pH-Sensoren mit pH-sensitiver Glasmembran und vergleichbaren Sensoren zur Messung anderer Ionen, Wässerungskappen bekannt, welche für den Transport, die Lagerung und/oder die Aufbewahrung der Sensoren zwischen zwei Messungen über diese sensitive Glasmembran geschoben werden. Bekannte Wässerungskappen sind mit einer geeigneten Befeuchtungsflüssigkeit befüllt, um ein Austrocknen der Glasmembran zu verhindern.

Die US 5,762,185 A offenbart eine Wässerungskappe zur Befeuchtung der Glasmembran eines pH-Sensors, wenn dieser nicht im Einsatz ist. Die Wässerungskappe ist an einem Ende offen zur Einführung der Elektrode und weist dort eine Einrichtung zur Befestigung am Elektrodenschaft auf. Weiterhin umfasst die Wässerungskappe eine Dichtung, um die Befeuchtungsflüssigkeit zurückzuhalten. Weitere Wässerungskappen sind von verschiedenen Herstellern von pH-Glas-Sensoren bekannt.

Das zweite Gehäusesegment kann ferner einen Anschlag für ein Ende der elektrochemischen Elektrode umfassen. Auf diese Weise ist die Einschubtiefe der Elektrode in die Schutzvorrichtung begrenzt.

Das Gehäuse der Schutzvorrichtung ist vorzugsweise aus Polycarbonat, Polymethylmethacrylat (PMMA) oder Polyethylenterephthalat (PET-G) gefertigt. Diese Materialien sind relativ fest und eignen sich daher besonders gut für das mechanisch stabile Gehäuse.

Das Befestigungselement der Schutzvorrichtung ist vorzugsweise aus Polycarbonat oder Polyoxymethylen (POM) gefertigt ist. Sinnvollerweise müssen die Materialien der Schutzvorrichtung, ebenso wie die Dichtungsringe, beständig gegen die Flüssigkeiten sein, mit denen sie im Gebrauch in Berührung kommen; insbesondere müssen sie beständig gegen den in der Elektrode verwendeten Elektrolyten sein.

Ein weiterer Aspekt der Erfindung betrifft ein Transport- und Aufbewahrungs-System mit einer erfindungsgemässen Schutzvorrichtung und einer elektrochemischen Elektrode mit einer Flüssigkeitsverbindung, wobei die Flüssigkeitsverbindung bei dem Transport, der Lagerung und/oder der Aufbewahrung im ersten Schutzraum der Schutzvorrichtung angeordnet ist.

Ein solches System ermöglicht, dass die Flüssigkeitsverbindung der in einer Schutzvorrichtung angeordneten elektrochemischen Elektrode gegenüber der Umgebung abgedichtet ist, wobei infolge des kleinen Volumens des ersten Schutzraumes bei der Herstellung des Druckausgleichs zwischen dem Inneren der Elektrode und dem ersten Schutzraum nach wie vor ein genügend grosser Überdruck innerhalb der Elektrode herrscht, um die Funktionsfähigkeit der Elektrode nach der Lagerung, dem Transport oder der Aufbewahrung zu gewährleisten.

Die elektrochemische Elektrode umfasst vorzugsweise einen unter Druck stehenden fliessfähigen Elektrolyten, so dass der Elektrolyt durch die Flüssigkeitsverbindung hindurch in den ersten Schutzraum austritt. Die Flüssigkeitsverbindung, oder auch Liquid Junction genannt, ist die Verbindungsstelle zwischen dem Elektrolyten innerhalb der Elektrode und des zu untersuchenden Mediums. Als Flüssigkeitsverbindung kommen kleine Öffnungen, Keramikdiaphragmen oder auch Schliffdiaphragmen in Frage. Diese ermöglichen es, dass der Elektrolyt langsam aus der bedruckten Elektrode herausfliessen kann. Der Elektrolyt ist zumindest fliessfähig und vorzugsweise flüssig.

Die elektrochemische Elektrode kann als elektrochemische Referenzelektrode oder als Teil einer Einstabmesskette ausgestaltet sein.

Die Erfindung wir im Folgenden anhand der stark schematisierten Zeichnungen erläutert, wobei gleiche Elemente mit vergleichbaren Bezugszeichen bezeichnet werden. Es zeigen:
- Fig. 1: eine Ausführungsform einer Schutzvorrichtung für eine Elektrode mit Flüssigkeitsverbindung im Gebrauchszustand, wobei die Schutzvorrichtung im Schnitt dargestellt ist;
- Fig. 2: eine Explosionsdarstellung einer weiteren Ausführungsform einer Schutzvorrichtung mit einem Gehäuse und einem Befestigungselement im Schnitt;
- Fig. 3: eine Explosionsdarstellung einer weiteren Ausführungsform einer Schutzvorrichtung mit einem Gehäuse, welches ein erstes und zweites Gehäusesegment umfasst, und einem Befestigungselement im Schnitt;
- Fig. 4: eine weitere Ausführungsform einer Schutzvorrichtung mit erstem und zweitem Schutzraum für eine Elektrode mit Flüssigkeitsverbindung im Gebrauchszustand, wobei die Schutzvorrichtung im Schnitt dargestellt ist;
- Fig. 5: eine weitere Ausführungsform einer Schutzvorrichtung für eine Elektrode mit Flüssigkeitsverbindung im Gebrauchszustand, wobei die Schutzvorrichtung im Schnitt dargestellt ist;
- Fig. 6: eine weitere Ausführungsform einer Schutzvorrichtung mit Gehäuse und Befestigungselement für eine Elektrode mit Flüssigkeitsverbindung im montierten Zustand, wobei das Gehäuse im Schnitt dargestellt ist;
- Fig. 7: eine perspektivische Ansicht einer weiteren Ausführungsform einer Schutzvorrichtung mit Bajonettverschluss im montierten Zustand.

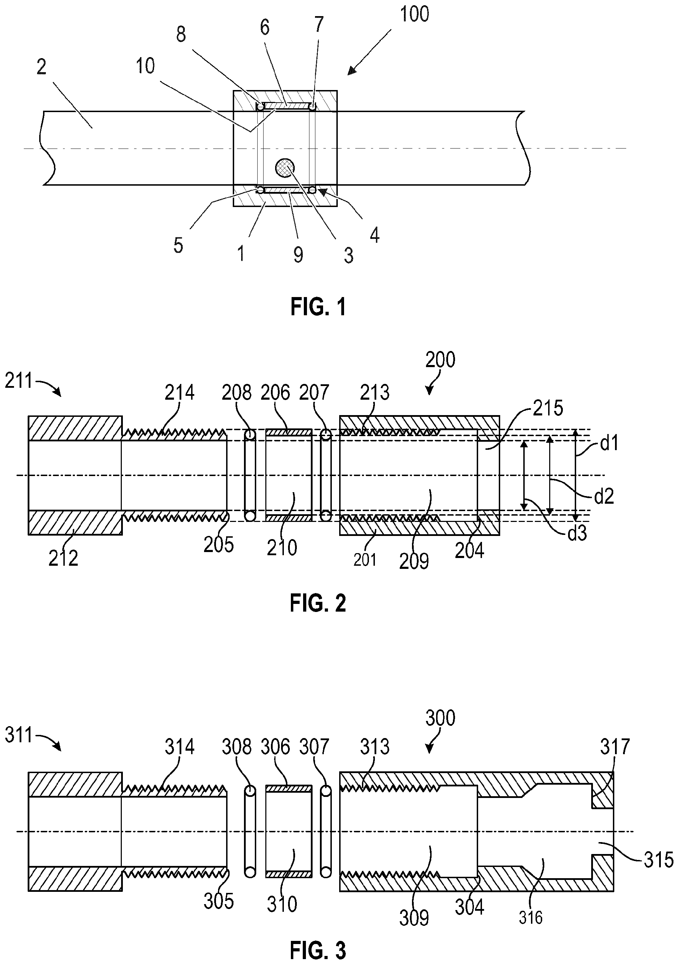

Figur 1 zeigt eine Ausführungsform einer Schutzvorrichtung 100 für eine elektrochemische Elektrode 2 mit einer Flüssigkeitsverbindung 3 im Gebrauchszustand, wobei die Schutzvorrichtung 100 im Schnitt dargestellt ist. Die Elektrode 2 ist hier nur angedeutet, und kann jegliche Art von elektrochemischer Elektrode mit einer Flüssigkeitsverbindung 3 darstellen. Insbesondere eine elektrochemische Referenzelektrode oder einen Sensor mit einer elektrochemischen Referenzelektrode mit Flüssigkeitsverbindung.

Die Schutzvorrichtung 100 umfasst ein als Hohlzylinder ausgestaltetes Gehäuse 1, welches an beiden Enden offen ist, und weist in dieser Ausführungsform einen im Inneren des Gehäuses 1 umlaufenden ersten Absatz 4 und ein Begrenzungsmittel 5 auf, welches hier als im Inneren des Gehäuses 1 umlaufender zweiter Absatz ausgestaltet ist. Die beiden Absätze 4, 5 sind so gestaltet, dass sich zwischen ihnen ein erstes Gehäusesegment 9 mit einem vergrösserten Innendurchmesser d1 (s. Fig. 2) ausdehnt. In diesem ersten Gehäusesegment 9 sind im hier gezeigten Gebrauchszustand ein Zwischenstück 6, sowie ein erster Dichtring 7und zweiter Dichtring 8 angeordnet. Das Zwischenstück 6 ist als Hohlzylinder ausgestaltet und hat einen Aussendurchmesser, welcher ungefähr dem Innendurchmesser d1 des Gehäusesegments 9 entspricht, so dass das Zwischenstück 6 mit etwas Spiel im Gehäusesegment 9 angeordnet ist. Der Innendurchmesser d2 (s. Fig. 2) des Zwischenstücks 6 ist so bemessen, dass sich zwischen dem Zwischenstück 6 und der Elektrode 2 ein erster Schutzraum 10 ausbilden kann. Dazu ist das Zwischenstück 6 im Gehäuse 1 mit etwas Spiel und somit verschieblich oder beweglich gelagert. Die beiden Dichtringe 7, 8, sind hier elastisch verformbare polymere Dichtringe und dichten im Gebrauchszustand den ersten Schutzraum 10 gegen die Elektrode 2 ab, so das die Flüssigkeitsverbindung 3 im Schutzraum 10 angeordnet ist und ein in der Elektrode enthaltener Elektrolyt durch die Flüssigkeitsverbindung 3 nur in den Schutzraum 1 eindringen kann.

Figur 2 zeigt eine Explosionsdarstellung einer weiteren Ausführungsform einer Schutzvorrichtung 200 mit einem Gehäuse 201, einem Befestigungselement 211 und einem Zwischenstück 206 im Schnitt.

Das Gehäuse 201 ist als beidseitig offener Hohlzylinder ausgestaltet, wobei das Gehäuse 201 wiederum einen ersten Absatz 204 aufweist, welcher ein erstes Gehäusesegment 209 mit einem ersten Innendurchmesser d1 von einer Öffnung 215 mit einem dritten Innendurchmesser d3 abgrenzt. Das der Öffnung 215 entgegenliegende Ende des Gehäuses 201 weist zudem ein erstes Verbindungsmittel 213 auf, welches hier als Innengewinde ausgestaltet ist.

Das Befestigungselement 211 ist auch als Hohlzylinder gestaltet und weist einen im Wesentlichen gleichförmigen Innendurchmesser auf, welcher ungefähr dem Durchmesser d3 der Öffnung 215 entspricht. Auf diese Weise kann gewährleistet werden, dass die Schutzvorrichtung 211 wie z. B. in Fig. 1 gezeigt auf eine Elektrode aufgesetzt werden kann, um deren Flüssigkeitsverbindung im ersten Schutzraum zu platzieren. Das Befestigungselement 211 weist an seinem im montierten Zustand dem Gehäuse 201 zugewandten Ende ein Begrenzungsmittel 205, welches hier die Abschlusskante des Befestigungselements 211 ist, und ein zweites Verbindungsmittel 214 auf, das als Aussengewinde ausgebildet ist. Das zweite Verbindungsmittel 214 steht im montierten Zustand mit dem ersten Verbindungsmittel 213 im Eingriff.

Das Befestigungselement 211 weist an einem Ende ein Griffsegment 212 auf, welche beispielsweise aussen geriffelt sein kann, um ein Einsetzen in und Verschrauben mit dem Gehäuse 201 zu ermöglichen, so dass im Gebrauchszustand das Begrenzungsmittel 205 gegen den zweiten Dichtringe 207 anstösst, dadurch Druck auf das Zwischenstück 206 sowie beide Dichtringe 207, 208 ausübt und so den ersten Schutzraum 210 gegen eine Elektrode abdichtet.

Die Schutzvorrichtung 200 wird in ihren Gebrauchszustand (s.a. Figuren 1, 4 und 5) gebracht indem das Befestigungsmittel 211 und das Gehäuse 201 zusammen oder nacheinander auf eine zu schützende Elektrode geschoben. Das Gehäuse 201 wird dabei am nahe der Öffnung 215 liegenden Ende festgehalten, während das Befestigungselement 211 mit dem Gehäuse 201 verbunden wird, bis die Schutzvorrichtung 200 korrekt an der Elektrode angebracht ist die Flüssigkeitsverbindung wie bereits beschrieben abdichtet.

Figur 3 zeigt eine Explosionsdarstellung einer weiteren Ausführungsform einer Schutzvorrichtung 300 mit einem Gehäuse 301, welches ein erstes Gehäusesegment 309 und ein zweites Gehäusesegment 316 umfasst, mit einem Befestigungselement 311, einem Zwischenstück 306 und einem ersten und zweiten Dichtring 307, 308 im Schnitt.

Das Befestigungselement 311, das Zwischenstück 306, die beiden Dichtringe 307, 308 sowie das erste Gehäusesegment 309 entsprechen im Wesentlichen den bereits in Zusammenhang mit Figur 2 beschriebenen Elementen.

Zusätzlich umfasst das Gehäuse 301 ein zweites Gehäusesegment 316, welches an das erste Gehäusesegment 309 anschliesst und in welchem einen Anschlag 317 für ein Ende der Elektrode ausgeprägt ist. Vorzugsweise stellen das erste und zweite Gehäusesegment 309, 316 ein einzelnes Bauteil dar oder sind einstückig ausgestaltet.

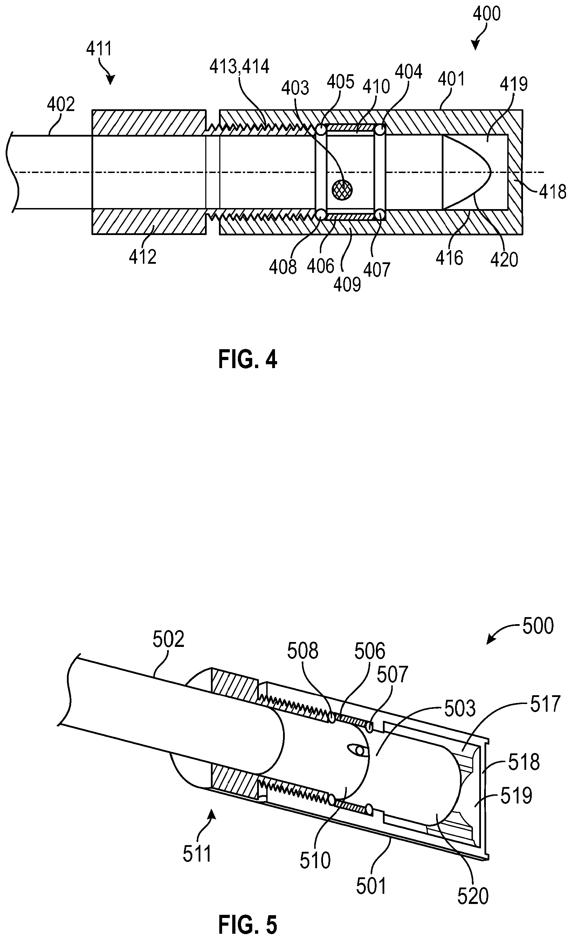

Figur 4 zeigt eine weitere Ausführungsform einer Schutzvorrichtung 400 im Gebrauchszustand mit einem Gehäuse 401, einem Befestigungselement 411, einem Zwischenstück 406 und einem ersten und zweiten Dichtring 407, 408.

Das Gehäuse 401 umfasst ein erstes Gehäusesegment 309 in welchem die beiden Dichtringe 407, 408 und das Zwischenstück 406 unter Ausbildung eines ersten Schutzraums 410 für eine Flüssigkeitsverbindung 403 einer Elektrode 402 angeordnet sind. Das Befestigungselement 411 umfasst ein Begrenzungsmittel 405, welches hier Druck auf den zweiten Dichtring 408, das Zwischenstück 406 und den ersten Dichtring 407 ausübt, so dass der erste Schutzraum gegen die Elektrode 402 abgedichtet ist.

Zudem umfasst das Gehäuse 401 einen zweiten Schutzraum 419, welche durch den ersten Absatz 404 und ein hier geschlossenes Ende 418 des Gehäuses 401 gebildet ist. Dieser Schutzraum 419 nimmt im Gebrauchszustand ein sensitives Ende 420 der Elektrode 402 auf und kann zudem eine Benetzungsflüssigkeit enthalten, welche zum Beispiel dazu dient das sensitive Ende 420 während des Transports, der Lagerung oder der Aufbewahrung zu befeuchten.

Figur 5 zeigt eine weitere Ausführungsform einer Schutzvorrichtung 500 für eine Elektrode 502 mit Flüssigkeitsverbindung 503 im Gebrauchszustand, wobei die Schutzvorrichtung 500 im Schnitt dargestellt ist.

Die Flüssigkeitsverbindung 503 befindet sich wie hier gezeigt im ersten Schutzraum 510 und ein sensitives Ende 520 der Elektrode 502 befindet sich im zweiten Schutzraum 519, welcher im einseitig geschlossenen zweiten Gehäusesegment angeordnet ist und einen Anschlag 517 für die Elektrode 502 umfasst. Der Anschlag 517 kann sowohl fest mit dem Gehäuse 501 verbunden sein, als auch als herausnehmbarer Einsatz ausgestaltet sein.

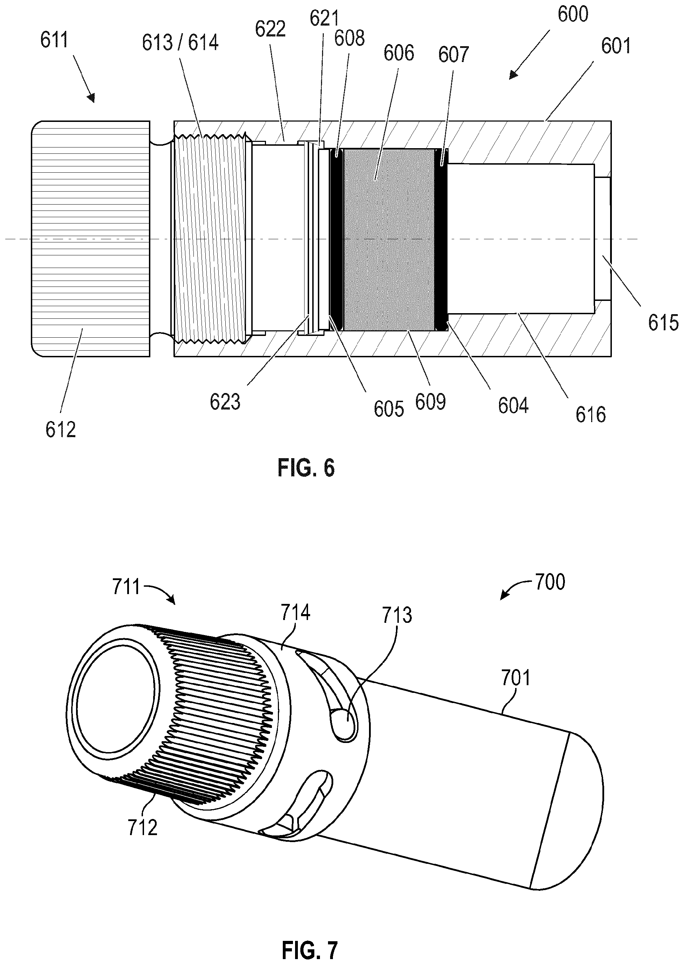

Figur 6 zeigt eine weitere Ausführungsform einer Schutzvorrichtung 600 mit Gehäuse 601 und Befestigungselement 611 für eine Elektrode mit Flüssigkeitsverbindung im montierten Zustand, wobei nur das Gehäuse im Schnitt dargestellt ist.

Wie bereits im Zusammenhang mit den Figuren 1 bis 5 beschrieben umfasst die Schutzvorrichtung 600 zudem ein Zwischenstück 606 und einen ersten und zweiten Dichtring 607, 608, welche im gezeigten montierten Zustand in einem ersten Gehäusesegment 609 angeordnet sind, welches auf der einen Seite durch einen im Gehäuse 601 umlaufend ausgebildeten ersten Absatz 604 und ein hier am Befestigungselement 611 ausgebildeten Begrenzungsmittel 605 gebildet wird. Weiterhin kann die Schutzvorrichtung 600 ein zweites Gehäusesegment 616 umfassen, welches an das erste Gehäusesegment 609 anschliesst und hier mit nach aussen offenen Ende 615 dargestellt ist. Die Innendurchmesser der verschiedenen Elemente entsprechen im Wesentlichen denen in den vorangehenden Figuren.

Zusätzlich weist das Gehäuse 601 ein drittes Gehäusesegment 621 auf, welches als umlaufende Nut ausgebildet ist und von einem dritten Absatz 622 begrenzt ist. Das dritte Gehäusesegment 621 schliesst auf der Seite, die dem Befestigungselement 611 zugewandt ist, an das erste Gehäusesegment 609 an.

Das Befestigungsmittel 611 weist wiederum ein Griffsegment 612 und das Begrenzungsmittel 605 auf. Zudem weist es einen Wulst 623 auf, welche in der Nähe des Begrenzungsmittels 605 angeordnet ist. Dieser Wulst 623 greift im montierten Zustand mit Spiel in die Nut 621 ein und hält so das Befestigungselement 611 und das Gehäuse 601 zusammen und sichert zudem die beiden Dichtringe 607, 608 und das Zwischenstück 606 gegen Verlieren oder das Herausfallen. Sobald eine Elektrode in die Schutzvorrichtung 600 eingesetzt wird, kann das Befestigungselement 611 tiefer in das Gehäuse eingeschraubt werden, so dass die beiden Dichtringe 607, 608 einen ersten Schutzraum gegen die Elektrode abdichten, wobei die Nut 621 das Eindringen des Befestigungselements 611 begrenzt und somit auch den auf die beiden Dichtringe 607, 608 einwirkenden Druck limitiert. Dazu weisen das Befestigungselement 611 und das Gehäuse 601 jeweils ein Verbindungsmittel 613, 614 auf, welche im montierten Zustand im Eingriff sind und z.B. als Aussen- bzw. Innengewinde ausgestaltet sind.

Figur 7 zeigt eine perspektivische Ansicht einer weiteren Ausführungsform einer Schutzvorrichtung 700 mit Bajonettverschluss im montierten Zustand und somit ohne Elektrode.

Die Schutzvorrichtung 700 umfasst ein Gehäuse 701 und ein Befestigungselement 711, welche sich von den in den Figuren 2 bis 6 gezeigten Ausführungsformen darin unterscheiden, dass anstelle einer Schraubverbindung ein Bajonettverschluss zum Verbinden und Lösen von Gehäuse 701 und Befestigungselement 711 vorhanden ist. Das Gehäuse 701 weist dabei nahe seinem dem Befestigungselement 711 zugewandten Ende ein ersten Verbindungselement 713 mit mehreren am Umfang angeordnete Ausbuchtungen auf und das Befestigungselement 711 ein entsprechendes zweites Verbindungselement 714 mit länglichen, schräg zum Umfang angeordnete Rastöffnungen auf. Diese Rastöffnungen sind mit an der Innenseite des Befestigungselements 711 in Längsrichtung der Schutzvorrichtung 700 verlaufenden Einführungsnuten verbunden, wobei diese sich bis zum dem Gehäuse 701 zugewandten Ende des Befestigungselements 711 erstrecken. Am dem Gehäuse 701 abgewandten Ende des Befestigungselements 711 ist zur besseren Handhabung ein Griffsegment 712 mit einer Rändelung angebracht.

Beim Aufsetzen des Befestigungselementes 711 auf das Gehäuse 701 werden die Ausbuchtungen durch die Einführungsnuten in die Rastöffnungen geführt. In diesem Fall befindet sich die Schutzvorrichtung 700 in ihrem montierten Zustand.

Nach Einführen einer Elektrode in die Schutzvorrichtung 700 werden die Ausbuchtungen durch Drehen des Befestigungselementes 711 gegenüber dem Gehäuse 701 in den Rastöffnungen derart geführt, dass sie in die in den Rastöffnungen eingearbeiteten Rastpositionen gelangen und dort eine form- und kraftschlüssige Verbindung herstellen.

Dabei wird bei eingerasteten Ausbuchtungen in die Rastpositionen der Rastöffnungen infolge der schrägen Anordnung der Rastöffnungen und der damit verbundenen Verschiebung des Befestigungselements 711 in Bezug auf das Gehäuse 701 in Längsrichtung des Schutzaufsatzes 700 ebenfalls eine Kraft auf die beiden Dichtungsringe (siehe Figuren 1 bis 6) ausgeübt. Diese verformen sich entsprechend, wie bereits vorangehend ausgeführt, und dichten damit, mit dem Zwischenstück eine erste Schutzkammer bildend, den Bereich um die Flüssigkeitsverbindung zwischen der Elektrode, genauer dem Schaft der elektrochemischen Elektrode und der Innenwand des Gehäuses 701 ab. Anstelle von Rastöffnungen können auch Rastvertiefungen in das Befestigungselement 711 eingearbeitet sein.

Als Material für das Gehäuse und das Zwischenstück kommen insbesondere feste Polymere, wie Polycarbonat, Acrylglas oder Polyethylenterepthalat (PET), insbesondere PET-G, usw. in Betracht. Metalle oder Glas könnten für den Einsatz unter bestimmten Bedingungen verwendet werden, beispielweise für besonders hygienische oder sehr harsche Bedingungen. Für das Befestigungselement können entweder flexible Polymere, wie Polyethylen (PE) oder Polyoxymethylen (POM) gewählt werden, jedoch werden auch hier mit Vorteil feste Polymere, wie Polycarbonat, verwendet. Sinnvollerweise müssen diese Materialien, ebenso wie das Material der beiden Dichtungsringe beständig gegen die Flüssigkeiten sein, mit denen sie im Gebrauch in Berührung kommen; insbesondere müssen sie beständig gegen dem Elektrolyten der Elektrode und/oder der Benetzungsflüssigkeit sein.

Die Schutzvorrichtung erfüllt im Gebrauchszustand die Funktionen des Abdichtens der Flüssigkeitsverbindung und zudem je nach Ausführungsform auch des mechanischen Schutzes einer elektrochemischen Elektrode. Die Schutzvorrichtung kann dabei vor allem die Flüssigkeitsverbindung und ein Ende der Elektrode schützen oder zusätzlich ein Reservoir für eine Benetzungsflüssigkeit in Form des zweiten Schutzraumes umfassen und so ein sensitives Ende oder einen sensitiven Bereich der Elektrode feucht halten. Als sensitiver Bereich wird hier der Bereich der Elektrode bezeichnet, an welchem ein Messelement angeordnet ist.

Die Erfindung wurde anhand von bevorzugten Ausführungsformen gezeigt und beschrieben. Es sollen jedoch hier nicht ausdrücklich genannte Ausführungen und Weiterbildungen der Erfindung vom Schutzumfang umfasst sein. Beispielsweise kann an Stelle einer als Einstabmesskette ausgebildeten elektrochemischen Elektrode auch lediglich eine einfache unter Überdruck stehende Referenzelektrode mit einer Referenzflüssigkeit in Verbindung mit einem Schutzaufsatz ein System zur Aufbewahrung und zum Transport einer elektrochemischen Elektrode bilden. Es ist zudem möglich, die gezeigten Befestigungselemente und Gehäusevariationen im Rahmen des durch die Ansprüche definierten Schutzumfangs beliebig zu kombinieren.

### Liste der Bezugszeichen

- 100, 200, 300, 400, 500, 600, 700: Schutzvorrichtung
- 1, 201, 301, 401, 501, 601, 701: Gehäuse
- 2, 402, 502: Elektrode
- 3, 403, 503: Flüssigkeitsverbindung
- 4, 204, 304, 404: Erster Absatz
- 5, 205, 305, 405, 605: Begrenzungsmittel
- 6, 206, 306, 406, 506, 606: Zwischenstück
- 7, 207, 207, 307, 407, 507, 607: Erster Dichtring
- 8, 208, 308, 408, 508, 608: Zweiter Dichtring
- 9, 209, 309, 609: Erstes Gehäusesegment
- 10, 210, 310, 410: Erster Schutzraum
- 211, 311, 411, 511, 611, 711: Befestigungselement
- 212,412,612,712: Griffsegment
- 213, 313, 413, 613, 713: Erstes Verbindungsmittel
- 214, 314, 414, 614, 714: Zweites Verbindungsmittel
- 215,315,615: Öffnung
- 316, 416, 616: Zweites Gehäusesegment
- 317,517: Anschlag
- 418, 518: Geschlossenes Ende
- 419, 519: Zweiter Schutzraum
- 420, 520: Sensitiver Bereich
- 621: Drittes Gehäusesegment / Nut
- 622: Dritter Absatz
- 623: Wulst

## Patentansprüche

1. Schutzvorrichtung für elektrochemische Elektroden mit einer Flüssigkeitsverbindung (3, 403, 503), umfassend:
ein Gehäuse (1, 201, 301, 401, 501, 601, 701), welches als Hohlzylinder ausgestaltet ist und welches einen in seinem Inneren umlaufenden ersten Absatz (4, 204, 304, 404) aufweist;
ein Begrenzungsmittel (5, 205, 305, 405, 605), welches zusammen mit dem ersten Absatz ein erstes Gehäusesegment (9, 209, 309, 609) mit einem ersten Innendurchmesser begrenzt;
ein Zwischenstück (6, 206, 306, 406, 506, 606), welches als Hohlzylinder mit einem dem ersten Innendurchmesser entsprechenden Aussendurchmesser ausgestaltet ist;
einen ersten Dichtring (7, 207, 307, 407, 507, 607) und einen zweiten Dichtring (8, 208, 308, 408, 508, 608), zwischen denen das Zwischenstück angeordnet ist;
wobei der erste Dichtring, der zweite Dichtring und das Zwischenstück im Inneren des ersten Gehäusesegments angeordnet sind, so dass der erste Dichtring und der zweite Dichtring einen ersten Schutzraum (10, 210, 310, 410) für die Flüssigkeitsverbindung begrenzen, dessen Aussendurchmesser dem Innendurchmesser des Zwischenstücks entspricht.

2. Schutzvorrichtung gemäss Anspruch 1, **dadurch gekennzeichnet, dass** das Begrenzungsmittel als zweiter Absatz (5) in Inneren des Gehäuses ausgestaltet ist.

3. Schutzvorrichtung gemäss Anspruch 1 oder 2, **dadurch gekennzeichnet, dass** das Gehäuse ein erstes Verbindungsmittel (213, 313, 413, 613, 713) umfasst; und dass die Schutzvorrichtung ferner ein Befestigungselement (211, 311, 411, 511, 611, 711) umfasst, welches als Hohlzylinder ausgestaltet ist und das Begrenzungsmittel sowie ein zweites Verbindungsmittel (214, 314, 414, 614, 714) zur Verbindung des Befestigungselements mit dem Gehäuse umfasst; wobei das Begrenzungsmittel an einem ersten Ende des Befestigungselements angeordnet ist, so dass im zusammengebauten Zustand das Begrenzungsmittel gegen den zweiten Dichtungsring gepresst wird und so Druck auf den ersten und zweiten Dichtring ausübt.

4. Schutzvorrichtung gemäss Anspruch 3, **dadurch gekennzeichnet, dass** das erste Verbindungsmittel (213, 313, 413, 613) als Innengewinde und das zweite Verbindungsmittel (214, 314, 414, 614) als Aussengewinde ausgestaltet ist.

5. Schutzvorrichtung gemäss Anspruch 3, **dadurch gekennzeichnet, dass** das erste Verbindungsmittel (713) und das zweite Verbindungsmittel (714) als Teile einer Bajonettverbindung ausgestaltet sind.

6. Schutzvorrichtung gemäss einem der Ansprüche 3 bis 5, **dadurch gekennzeichnet, dass** das Befestigungselement an einem zweiten Ende ein strukturiertes Griffsegment (212, 412, 612, 712) umfasst.

7. Schutzvorrichtung gemäss Anspruch 6, **dadurch gekennzeichnet, dass** das Befestigungselement einen Wulst (623) umfasst, welche zwischen dem Griffsegment (612) und dem Begrenzungsmittel (605) angeordnet ist, wobei der Wulst im zusammengebauten Zustand mit Spiel in eine Nut (621) am Gehäuse eingreift und so einen Anschlag für das Befestigungselement bildet.

8. Schutzvorrichtung gemäss einem der Ansprüche 1 bis 7, **dadurch gekennzeichnet, dass** das Gehäuse ein zweites Gehäusesegment (316, 416, 616) umfasst, welches als Hohlzylinder ausgestaltet und endständig mit dem ersten Gehäusesegment verbunden ist.

9. Schutzvorrichtung gemäss Anspruch 8, **dadurch gekennzeichnet, dass** das zweite Gehäusesegment einseitig geschlossen ist, so dass im Inneren des zweiten Gehäusesegments ein zweiter Schutzraum (419, 519) zur Aufnahme einer Befeuchtungsflüssigkeit ausgebildet ist.

10. Schutzvorrichtung gemäss einem der Ansprüche 8 oder 9, **dadurch gekennzeichnet, dass** das zweite Gehäusesegment einen Anschlag (317, 517) für ein Ende der Elektrode umfasst.

11. Schutzvorrichtung nach einem der Ansprüche 1 bis 10, **dadurch gekennzeichnet, dass** das Gehäuse aus Polycarbonat, Polymethylmethacrylat (PMMA) oder Polyethylenterephthalat (PET-G) gefertigt ist.

12. Schutzvorrichtung nach einem der Ansprüche 3 bis 11, **dadurch gekennzeichnet, dass** das Befestigungselement aus Polycarbonat oder Polyoxymethylen (POM) gefertigt ist.

13. Transport- und Aufbewahrungs-System mit einer Schutzvorrichtung (100, 200, 300, 400, 500, 600, 700) nach einem der vorangehenden Ansprüche und einer elektrochemischen Elektrode (2, 402, 502) mit einer Flüssigkeitsverbindung (3, 403, 503), wobei die Flüssigkeitsverbindung der elektrochemischen Elektrode bei dem Transport, der Lagerung und/oder der Aufbewahrung im ersten Schutzraum der Schutzvorrichtung angeordnet ist.

14. Transport- und Aufbewahrungs-System gemäss Anspruch 13, **dadurch gekennzeichnet, dass** die elektrochemische Elektrode einen unter Druck stehenden fliessfähigen Elektrolyten umfasst, so dass der Elektrolyt durch die Flüssigkeitsverbindung hindurch in den ersten Schutzraum austritt.

15. Transport- und Aufbewahrungs-System gemäss Anspruch 13 oder 14, **dadurch gekennzeichnet, dass** die elektrochemische Elektrode eine elektrochemische Referenzelektrode oder Teil einer Einstabmesskette ist.

## Claims

1. A protective device for electrochemical electrodes having a liquid junction (3, 403, 503) comprising:
a casing (1, 201, 301, 401, 501, 601, 701) which is configured as a hollow cylinder and which has an inner circumferential first protrusion (4, 204, 304, 404);
a delimiting means (5, 205, 305, 405, 605) which together with the first protrusion delimits a first casing segment (9, 209, 309, 609) with a first inner diameter;
a spacer (6, 206, 306, 406, 506, 606), which is configured as a hollow cylinder having an outer diameter corresponding to the first inner diameter;
a first sealing ring (7, 207, 307, 407, 507, 607) and a second sealing ring (8, 208, 308, 408, 508, 608) between which the spacer is disposed;
wherein the first sealing ring, the second sealing ring and the spacer are disposed in the interior of the first casing segment, so that the first sealing ring and the second seal ring delimit a first protection space (10, 210, 310, 410) for the liquid junction, the outer diameter of which corresponds to the inner diameter of the spacer.

2. The protective device according to claim 1, **characterized in that** the delimiting means is configured as the second protrusion (5) in the interior of the casing.

3. The protective device according to claim 1 or 2, **characterized in that** the casing comprises a first connecting means (213, 313, 413, 613, 713); and **in that** the protective device further comprises a fastening element (211, 311, 411, 511, 611, 711), which is configured as a hollow cylinder and comprises the delimiting means and a second connecting means (214, 314, 414, 614, 714) for connecting the fastening element with the casing; wherein the delimiting means is disposed at a first end of the fastening element, so that in the assembled state, the delimiting means is pressed against the second sealing ring and thus exerts pressure on the first and second sealing rings.

4. The protective device according to claim 3, **characterized in that** the first connecting means (213, 313, 413, 613) is configured as a female thread and the second connecting means (214, 314, 414, 614) is configured as a male thread.

5. The protective device according to claim 3, **characterized in that** the first connecting means (713) and the second connecting means (714) are configured as parts of a bayonet connection.

6. The protective device according to any one of claims 3 to 5, **characterized in that** the fastening element comprises a structured grip segment (212, 412, 612, 712) at a second end.

7. The protective device according to claim 6, **characterized in that** the fastening element comprises a bead (623) which is disposed between the grip segment (612) and the delimiting means (605), wherein, in the assembled state, the bead engages a groove (621) on the casing with clearance and thus forms a stop for the fastening element.

8. The protective device according any one of the claims 1 to 7, **characterized in that** the casing comprises a second casing segment (316, 416, 616) which is configured as a hollow cylinder and is connected terminally with the first casing segment.

9. The protective device according to claim 8, **characterized in that** the second casing segment is closed on one side so that in the interior of the second casing segment a second protection space (419, 519) for receiving a humidification liquid is formed.

10. The protective device according any one of claims 8 or 9, **characterized in that** the second casing segment comprises a stop (317, 517) for one end of the electrode.

11. The protective device according to any one of claims 1 to 10, **characterized in that** the casing is made of polycarbonate, polymethyl methacrylate (PMMA) or polyethylene terephthalate (PET-G).

12. The protective device according to any one of claims 3 to 11, **characterized in that** the fastening element is made of polycarbonate or polyoxymethylene (POM).

13. A transport and retention system with a protective device (100, 200, 300, 400, 500, 600, 700) according to any one of the preceding claims and an electrochemical electrode (2, 402, 502) having a liquid junction (3, 403, 503), wherein the liquid junction of the electrochemical electrode is disposed in the first protection space of the protective device during transport, storage and/or retention.

14. The transport and storage system according to claim 13, **characterized in that** the electrochemical electrode comprises a pressurized flowable electrolyte so that the electrolyte exits through the liquid junction in the first protection space.

15. The transport and storage system according to claim 13 or 14, **characterized in that** the electrochemical electrode is an electrochemical reference electrode, or part of a combination electrode.

## Revendications

1. Dispositif de protection pour électrodes électrochimiques à jonction liquide (3, 403, 503), comprenant :
un boîtier (1, 201, 301, 401, 501, 601, 701), qui est conçu comme un cylindre creux et qui présente un premier épaulement faisant le tour de son intérieur (4, 204, 304, 404) ;
un moyen de limitation (5, 205, 305, 405, 605), qui délimite avec le premier épaulement un premier segment de boîtier (9, 209, 309, 609) ;
une entretoise (6, 206, 306, 406, 506, 606) conçue comme un cylindre creux ayant un diamètre extérieur correspondant au premier diamètre intérieur ;
une première bague d'étanchéité (7, 207, 307, 407, 507, 607) et une seconde bague d'étanchéité (8, 208, 308, 408, 508, 608) entre lesquelles l'entretoise est disposée ;
dans lequel la première bague d'étanchéité, la seconde bague d'étanchéité et l'entretoise sont disposées à l'intérieur du premier segment de boîtier, de sorte que la première bague d'étanchéité et la seconde bague d'étanchéité délimite un premier espace de protection (10, 210, 310, 410) pour la jonction liquide, espace dont le diamètre intérieur correspond au diamètre intérieur de l'entretoise.

2. Dispositif de protection selon la revendication 1, **caractérisé en ce que** le moyen de limitation est conçu comme un second épaulement (5) à l'intérieur du boîtier.

3. Dispositif de protection selon la revendication 1 ou 2, **caractérisé en ce que** le boîtier comprend un premier moyen de liaison (213, 313, 413, 613, 713) ; et **en ce que** le dispositif de protection comprend en outre un élément de fixation (211, 311, 411, 511, 611, 711) conçu comme un cylindre creux et comprend le moyen de limitation ainsi qu'un second moyen de liaison (214, 314, 414, 614, 714) pour relier l'élément de fixation au boîtier ; dans lequel le moyen de limitation est disposé à une première extrémité de l'élément de fixation, de sorte qu'à l'état assemblé, le moyen de limitation est appuyé contre la seconde bague d'étanchéité et exerce ainsi une pression sur la première et la seconde bague d'étanchéité.

4. Dispositif de protection selon la revendication 3, **caractérisé en ce que** le premier moyen de liaison (213, 313, 413, 613) est conçu comme un filetage intérieur et le second moyen de liaison (214, 314, 414, 614) est conçu comme un filetage extérieur.

5. Dispositif de protection selon la revendication 3, **caractérisé en ce que** le premier moyen de liaison (713) et le second moyen de liaison (714) sont conçus comme des parties d'une connexion à baïonnette.

6. Dispositif de protection selon l'une des revendications 3 à 5, **caractérisé en ce que** l'élément de fixation comprend un segment de poignée structuré (212, 412, 612, 712) à une seconde extrémité.

7. Dispositif de protection selon la revendication 6, **caractérisé en ce que** l'élément de fixation comprend un bourrelet (623) disposé entre le segment de poignée (612) et l'élément de limitation (605), dans lequel le bourrelet à l'état assemblé vient en prise avec du jeu dans une rainure (621) sur le boîtier et forme ainsi une butée pour l'élément de fixation.

8. Dispositif de protection selon l'une des revendications 1 à 7, **caractérisé en ce que** le boîtier comprend un second segment de boîtier (316, 416, 616) qui est conçu comme un cylindre creux et est relié à une extrémité avec le premier segment de boîtier.

9. Dispositif de protection selon la revendication 8, **caractérisé en ce que** le second segment de boîtier est fermé d'un côté de sorte qu'un second espace de protection (419, 519) est formé à l'intérieur du second segment de boîtier pour recevoir un liquide d'humidification.

10. Dispositif de protection selon l'une des revendications 8 ou 9, **caractérisé en ce que** le second segment de boîtier comprend une butée (317, 517) pour une extrémité de l'électrode.

11. Dispositif de protection selon l'une des revendications 1 à 10, **caractérisé en ce que** le boîtier est fabriqué en polycarbonate, en polyméthacrylate de méthyle (PMMA) ou en polyéthylène téréphtalate (PET-G).

12. Dispositif de protection selon l'une des revendications 3 à 11, **caractérisé en ce que** l'élément de fixation est fabriqué en polycarbonate ou en polyoxyméthylène (POM).

13. Système de transport et de stockage doté d'un dispositif de protection (100, 200, 300, 400, 500, 600, 700) selon l'une des revendications précédentes et d'une électrode électrochimique (2, 402, 502) à jonction liquide (3, 403, 503), dans lequel la jonction liquide de l'électrode électrochimique est disposée dans le premier espace de protection du dispositif de protection lors du transport, de l'entreposage et/ou du stockage.

14. Système de transport et de stockage selon la revendication 13, **caractérisé en ce que** l'électrode électrochimique comprend un électrolyte fluide sous pression de sorte que l'électrolyte sort dans le premier espace de protection en traversant la jonction liquide.

15. Système de transport et de stockage selon la revendication 13 ou 14, **caractérisé en ce que** l'électrode électrochimique est une électrode de référence électrochimique, ou une partie d'une électrode combinée.
